# EUROPÄISCHE PATENTSCHRIFT

(11) **EP 2 659 233 B1**
(45) Veröffentlichungstag und Bekanntmachung des Hinweises auf die Patenterteilung: **21.10.2015**
(21) Anmeldenummer: 11808610.7
(22) Anmeldetag: 09.12.2011
(51) Int. Cl.: G01D 5/24, B25J 19/06, G01R 27/26, B25J 13/08, G01L 1/14, F16P 3/14

(54) **SENSORSYSTEM ZUR UMFELDÜBERWACHUNG AN EINEM MECHANISCHEN BAUTEIL UND VERFAHREN ZUR ANSTEUERUNG UND AUSWERTUNG DES SENSORSYSTEMS**
SENSOR SYSTEM FOR MONITORING SURROUNDINGS ON A MECHANICAL COMPONENT, AND METHOD FOR ACTUATING AND EVALUATING THE SENSOR SYSTEM
SYSTÈME DE DÉTECTION DESTINÉ À SURVEILLER L'ENVIRONNEMENT D'UNE PIÈCE MÉCANIQUE ET PROCÉDÉ DE COMMANDE ET D'ÉVALUATION DUDIT SYSTÈME DE DÉTECTION

(30) Priorität: 29.12.2010 DE 102010064328
(43) Veröffentlichungstag der Anmeldung: 06.11.2013
(73) Patentinhaber: Robert Bosch GmbH, 70442 Stuttgart (DE)
(72) Erfinder: FRANGEN, Joachim, 74081 Heilbronn (DE)
(86) Internationale Anmeldenummer: PCT/EP2011/072343
(87) Internationale Veröffentlichungsnummer: WO 2012/089486

(56) Entgegenhaltungen:
- WO-A2-2007/098171
- GB-A- 2 072 389
- GB-A- 2 141 873
- JP-A- 2008 004 465
- US-A- 4 584 625
- US-A- 4 908 574
- US-A- 5 656 785
- AKASOFU K ET AL: "A Thin-film Variable Capacitance Shear Force Sensor For Medical And Robotics Applications", NEW FRONTIERS OF BIOMEDICAL ENGINEERING - INNOVATIONS FROM NUCLEAR TO SPACE TECHNOLOGY : 13TH ANNUAL INTERNATIONAL CONFERENCE OF THE IEEE ENGINEERING IN MEDICINE AND BIOLOGY SOCIETY : OCTOBER 31 - NOVEMBER 3, 1991, ORLANDO, FLORIDA, USA ; PROCEEDINGS, 31. Oktober 1991 (1991-10-31), Seiten 1601-1602, XP010101531, ISBN: 978-0-7803-0216-7

## Beschreibung

### Stand der Technik

Die Erfindung betrifft ein Sensorsystem zur Umfeldüberwachung an einem mechanischen Bauteil nach dem Oberbegriff des Anspruchs 1. Ferner betrifft die Erfindung ein Verfahren zur Ansteuerung und Auswertung eines erfindungsgemäßen Sensorsystems.

Aus der nachveröffentlichten DE 10 2009 029 021 A1 der Anmelderin ist ein Sensorsystem nach dem Oberbegriff des Anspruchs 1 bekannt. Dieses, an Oberflächen von Maschinen oder Maschinenteilen anbringbare Sensorsystem weist wenigstens ein Sensorelement aus einem Schichtaufbau von flexiblen, elektrisch leitfähigen und elektrisch isolierenden Lagen auf. Mittels eines derartigen Sensorsystems lassen sich Annäherungen und/oder Kontakte eines Körpers oder eines Objektes messen, um beispielsweise den Betrieb eines ein Sensorsystem aufweisenden Montageroboters zu stoppen.

Weiterhin ist es an sich bekannt, dass zur automatischen Annäherungs- und/oder Kollisionserkennung eine Umfeldüberwachung der Maschine mit unterschiedlichen Sensorprinzipien und Sensoren, wie z.B. optische Sensoren, Ultraschallsensoren oder kapazitive Sensoren, beispielsweise auch mit einer Kontaktkrafterfassung über den piezoelektrischen Effekt, vorgenommen wird. Solche Sensoren können in der Regel in Sonderfällen eingesetzt werden, um beispielsweise einfach geformte Maschinenteile mit definierten Bewegungsbahnen zu überwachen, so dass bei einer Erkennung einer Annäherung eines Menschen beispielsweise ein sicheres Abbremsen der Antriebe oder der Bearbeitungsaggregate der Maschine ausgelöst werden kann.

Andererseits ist bei relativ komplex geformten Oberflächen oder einer komplexen Bahnbewegung des gefährdenden Maschinenteils eine lückenlose sensorische Umfeldüberwachung oft nur mit sehr hohem Aufwand oder eventuell auch gar nicht möglich. So kann beispielsweise an Kanten und Hinterschneidungen der Maschinenoberfläche die optische Erfassung durch Abschattungen behindert sein, oder es kann auch eine Integration von Sensoren an einem zu geringen Bauraum scheitern.

Für bedienersichere Maschinen ist es zur Erfüllung von Sicherheitsnormen üblich, Sicherheitseinrichtungen mit zwei voneinander unabhängigen Sicherheitskanälen mit Diagnosefunktion einzusetzen, so dass ein einzelner Fehler im System nicht zum Verlust der Sicherheit führt. Der Ausfall eines Sicherheitskanals wird sicher erkannt und gemeldet, während der zweite Sicherheitskanal die Sicherheitsfunktion aufrecht erhält. Bei solchen Anwendungen ist eine doppelt und unabhängig ausgeführte sensorische Überwachung erforderlich. Sensoren zur sicheren Gestaltung von Maschinen mit zwei Sicherheitskanälen, die flexibel an komplex geformten Oberflächen anpassbar sind, sind nicht bekannt.

Weiterhin ist aus der DE 20 2005 002 475 U1 eine speziell für die Anwendung zur Kollisionserkennung bei Industrierobotern ausgebildete Schaumstoffabdeckung bekannt, die mit annäherungserkennenden, taktilen und kapazitiven Sensoren ausgerüstet ist. Die Anbringung einer solchen Anordnung an unterschiedliche Industrieroboter ist allerdings oft aufwendig.

### Offenbarung der Erfindung

Ausgehend von dem dargestellten Stand der Technik liegt der Erfindung die Aufgabe zugrunde, ein einfach an unterschiedlichste Bauteile bzw. Oberflächen von Maschinen oder Maschinenteilen anbringbares Sensorsystem auszubilden, das gleichzeitig die Erfüllung von Sicherheitsnormen, die voneinander unabhängige Sicherheitskanäle mit Diagnosefunktion voraussetzen, ermöglicht. Diese Aufgabe wird bei einem Sensorsystem zur Umfeldüberwachung an einem mechanischen Bauteil mit den Merkmalen des Anspruchs 1 gelöst. Der Erfindung liegt dabei die Idee zugrunde, Sensorelemente mit einem Schichtaufbau von flexiblen, elektrisch leitfähigen und elektrisch isolierenden Lagen auszubilden, wobei elektrisch leitfähige Potenzialflächen einer Lage seitlich derart beabstandet über dazwischenliegende, isolierende Lagen angeordnet sind, dass sich elektrische Feldlinien zwischen den leitenden Potenzialflächen herausbilden, die sich bei Annäherung und/oder Kontakt eines Körpers oder eines Objekts messbar verändern, wobei der Schichtaufbau eines Sensorelements wenigstens zwei voneinander getrennt arbeitende Messelemente aufweist. Dabei wird durch den flexiblen Schichtaufbau eine einfache Anpassung bzw. Anbringung des Sensorelements bzw. des Sensorsystems an sich bewegenden Bauteilen von Maschinen bzw. komplex geformten Oberflächen der Maschinen ermöglicht und durch das Vorsehen wenigstens zwei voneinander getrennt arbeitender Messelemente je Sensorelement wird gleichzeitig die Erfüllung von Sicherheitsnormen ermöglicht.

Vorteilhafte Weiterbildungen des erfindungsgemäßen Sensorsystems zur Umfeldüberwachung an einem mechanischen Bauteil sind in den Unteransprüchen angegeben. In den Rahmen der Erfindung fallen sämtliche Kombinationen aus zumindest zwei von in den Ansprüchen, der Beschreibung und/oder den Figuren offenbarten Merkmalen.

Besonders bevorzugt ist eine Ausgestaltung der Erfindung, bei der das Sensorelement Mittel zum separaten Ansteuern und Auswerten der wenigstens zwei Messelemente umfasst. Dadurch ist sichergestellt, dass auch bei einer Beeinträchtigung bzw. Beschädigung eines Messelements das jeweils andere Mess-element weiterhin arbeiten kann.

Um eine gegenseitige Beeinträchtigung der Messwerte der wenigstens zwei Messelemente auszuschließen, ist es weiterhin vorgesehen, dass die Mittel zum separaten Ansteuern und Auswerten die wenigstens zwei Messelemente zeitlich aufeinanderfolgend ansteuern.

Um einen besonders sicheren und der Erfüllung von Sicherheitsnormen entsprechenden Betrieb von Maschinen zu ermöglichen, die eine Gefährdung, insbesondere für Personen, ausschließt, ist es darüber hinaus vorgesehen, dass Auswertemittel zum Auswerten der Messsignale der wenigstens zwei Messelemente vorgesehen sind, und dass die Auswertemittel mit den Maschinen oder Maschinenteilen zumindest mittelbar wirkverbunden sind und diese derart ansteuern, dass ein Betrieb der Maschinen oder Maschinenteile nur erfolgt, wenn die Signale der wenigstens zwei Messelemente innerhalb vorgegebener Grenzwerte liegen.

In einer konstruktiven Ausgestaltung der Sensorelemente, die eine Anpassung eines aus mehreren Sensorelementen bestehenden Sensorsystems an unter-schiedlichste Oberflächen von Maschinen oder Maschinenbauteilen ermöglicht, wird vorgeschlagen, dass das mindestens eine Sensorelement eine Grundfläche mit der Form eines Drei- oder Vierecks aufweist, und dass beim Vorhandensein mehrerer Sensorelemente diese miteinander elektrisch und mechanisch kontaktierbar sind und vorzugsweise eine Sensorhaut ausbilden.

Ein besonders kompakter und einfacher Aufbau der Sensorelemente wird darüber hinaus ermöglicht, wenn die Messelemente auf wenigstens einer Schicht gemeinsam angeordnet und räumlich voneinander getrennt sind.

Die Erfindung umfasst auch ein Verfahren zur Ansteuerung und Auswertung eines erfindungsgemäßen Sensorsystems. Hierbei ist vorgesehen, dass beim Vorhandensein mehrerer Sensorelemente wenigstens eine elektronische Auswerteeinrichtung mit Mitteln vorgesehen ist, die zyklisch die Sensorelemente adressiert und prüft, ob bei mindestens einem Sensorelement eine signifikante Veränderung der Kapazität gegenüber einem Referenzwert stattgefunden hat, und dass die Mittel die wenigstens zwei Messelemente eines Sensorelements zeitlich nacheinander adressieren. Ein derartiges Verfahren arbeitet besonders sicher und zuverlässig, da eine gegenseitige Beeinflussung der Messwerte der beiden Messelemente eines Sensorelements vermieden wird.

Eine besonders schnelle und somit sichere Erfassung von sich abzeichnenden Kollisionen wird ermöglicht, wenn zum gleichen Zeitpunkt ein Messelement eines ersten Sensorelements und ein anderes Messelement eines anderen Sensorelements von den Mitteln adressiert werden.

Der bauliche Aufwand bzw. der zur Verkabelung der Messelemente erforderliche Aufwand lässt sich reduzieren, wenn zur Adressierung linear verketteter Sensorelemente die Reihenfolge der Sensorelemente genutzt wird, indem die Daten entlang der Kette über mehrere Sensorelemente zu den Mitteln hin weitergeleitet werden.

Besonders bevorzugt ist weiterhin ein Verfahren, bei dem in einem weiteren Zyklus jedes Sensorelement einer Eigendiagnose unterzogen wird, wobei die Sensorelemente mit Prüfspannungen oder einem charakteristischen Signalmuster beaufschlagt werden. Mittels eines derartigen Verfahrens lassen sich insbesondere Beschädigungen an den Sensorelementen sicher erkennen, so dass ein besonders sicherer Betrieb eines Sensorsystems ermöglicht wird.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: ein einzelnes Sensorelement eines erfindungsgemäßen Sensorsystems in vereinfachter Draufsicht,
- Fig. 2: den Aufbau eines Sensorelements gemäß Fig. 1 in Explosionsdarstellung,
- Fig. 3 bis Fig. 5: gegenüber der Fig. 1 abgewandelte Sensorelemente mit anderen Formen in Draufsicht,
- Fig. 6 und Fig. 7: ein Sensorelement gemäß Fig. 1 während der Ansteuerung seiner beiden Messelemente zu unterschiedlichen Zeitpunkten in perspektivischer Ansicht,
- Fig. 8: ein Teil einer Sensorhaut unter Verwendung miteinander verbundener Sensorelemente in perspektivischer Ansicht,
- Fig. 9: ein Blockschaltbild zur Verdeutlichung der Ansteuerung der Messelemente eines Sensorelementes,
- Fig. 10: ein Blockschaltbild zur Darstellung eines aus mehreren Sensorelementen bestehenden Sensorsystems und
- Fig. 11: eine Darstellung der Ansteuerung der unterschiedlichen Messelemente der Sensorelemente durch unterschiedliche Zentraleinheiten.

Gleiche Bauteile bzw. Bauteile mit gleicher Funktion sind in den Figuren mit den gleichen Bezugsziffern versehen.

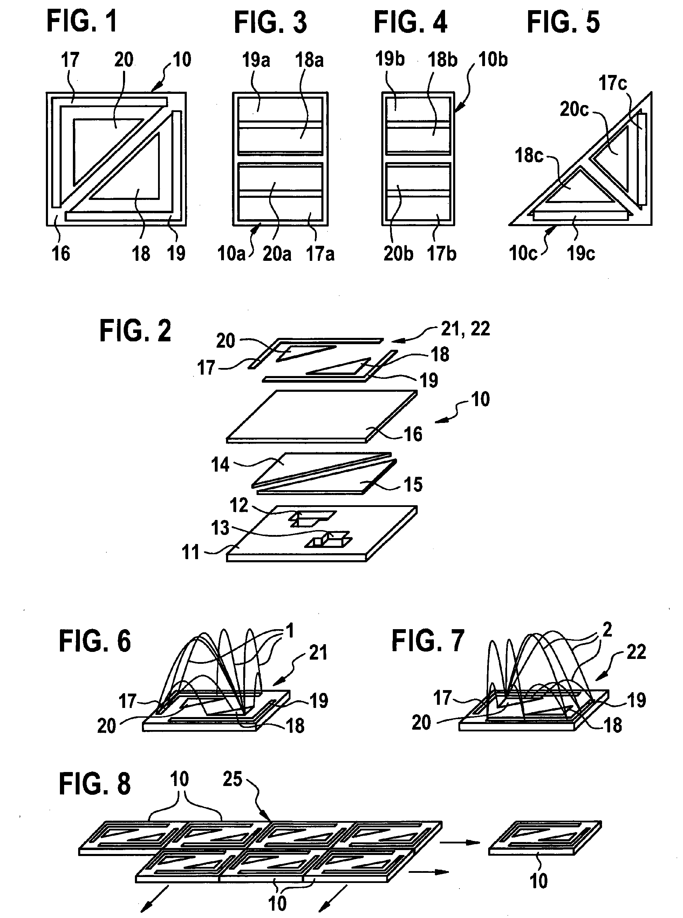

In den Fig. 1 und 2 ist ein Sensorelement 10 als Bestandteil eines später noch näher erläuterten Sensorsystems 100 dargestellt. Das Sensorsystem 100 bzw. das Sensorelement 10 dient hierbei zur Umfeldüberwachung an einem mechanischen Bauteil, beispielsweise an einem sich bewegenden Roboterarm eines Industrieroboters oder ähnlichem.

Wie insbesondere anhand der Fig. 2 erkennbar ist, weist das Sensorelement 10 einen Schichtaufbau aus mehreren miteinander verbundenen, flexiblen Schichten auf. Dieser Schichtaufbau beinhaltet beispielhaft und daher nicht einschränkend eine Basisschicht 11, beispielsweise aus Moosgummi oder Gummi mit einer Dicke von z.B. 5mm. Innerhalb der Basisschicht 11 sind zwei Aussparungen 12, 13 zur Aufnahme einer in den Fig. 1 und 2 nicht dargestellten Elektronik bzw. von elektronischen Bauteilen ausgebildet. Die Unterseite der Basisschicht 11 ist anliegend beispielsweise an das mechanische Bauteil angeordnet. Auf der Oberseite der Basisschicht 11 sind zwei voneinander getrennte, jeweils dreiecksförmige Masseflächen 14, 15 angeordnet. Die beiden Masseflächen 14, 15 bestehen beispielhaft aus einem Kupfervlies mit einer Dicke von 0,5mm. Die beiden Masseflächen 14, 15 sind auf der der Basisschicht 11 gegenüberliegenden Seite von einer Isolierschicht 16 überdeckt, die beispielhaft aus Moosgummi mit einer Dicke von 1,5mm besteht. Auf der Oberseite der Isolierschicht 16 ist diese mit insgesamt vier, insbesondere aus Kupfer bestehenden, elektrisch leitende Potentialflächen ausbildenden Elektrodenflächen 17 bis 20 verbunden. Während die einen Elektrodenflächen 17 und 19 jeweils in Form eines Winkels mit zwei gleichlangen Schenkeln ausgebildet sind, sind die beiden anderen Elektrodenflächen 18 und 20 jeweils dreiecksförmig ausgebildet. Darüber hinaus wirken die beiden Elektrodenflächen 17 und 19 als Sendeelektroden, während die beiden Elektrodenflächen 18 und 20 als Empfangselektroden wirken. Demgegenüber wirken die beiden Masseflächen 14 und 15 als Abschirmelektroden. Wesentlich ist noch, dass die Elektrodenflächen 17 bis 20 jeweils beabstandet zueinander angeordnet sind. Die Elektrodenflächen 17 und 18 bilden ein erstes Messelement 21 aus, während die beiden anderen Elektrodenflächen 19 und 20 ein zweites Messelement 22 ausbilden.

Wie insbesondere anhand der Fig. 6 und 7 erkennbar ist, bildet sich beim Anlegen einer Spannung an das erste Messelement 21 bzw. an das zweite Messelement 22 jeweils ein elektrisches Feld mit Feldlinien 1 bzw. 2 zwischen den jeweiligen Elektrodenflächen 17 und 18 bzw. 19 und 20 aus. Mit anderen Worten gesagt bedeutet dies, dass das erste Messelement 21 und das zweite Messelement 22 jeweils einen kapazitiven Sensor ausbilden, dessen Feldlinien 1 bzw. 2 sich bei einer Annäherung an einen Gegenstand oder an einen Menschen, beispielsweise ab einem Abstand kleiner 30mm bis 60mm, verändern. Diese Veränderung der Feldlinien 1, 2 resultiert in einer kapazitiven Änderung der beiden Messelemente 21 bzw. 22, die von dem Sensorelement 10 erfasst wird.

Um eine gegenseitige Beeinflussung der Messergebnisse der beiden Messelemente 21, 22 des Sensorelements 10 zu verhindern, die infolge von gleichzeitig vorhandenen Feldlinien 1, 2 vorhanden wäre, ist es erfindungsgemäß vorgesehen, dass die beiden Messelemente 21, 22 zeitlich nacheinander angesteuert werden. Dieser Sachverhalt ist in den Fig. 6 und 7 dargestellt, wobei in der Fig. 6 beispielhaft das erste Messelement 21 mit den Feldlinien 1 aktiviert ist, während das andere Messelement 22 deaktiviert ist. Demgegenüber ist in der Fig. 7 das zweite Messelement 22 aktiviert, so dass sich die Feldlinien 2 ausbilden, während das erste Messelement 21 deaktiviert ist.

Das in der Fig. 1 dargestellte Sensorelement 10 weist in Draufsicht eine quadratische Grundfläche mit beispielhaft etwa 60mm Kantenlänge auf. In den Fig. 3 und 4 sind modifizierte Sensorelemente 10a und 10b dargestellt, die jeweils eine rechteckförmige Grundfläche aufweisen. Hierbei weist das Sensorelement 10a beispielhaft Kantenlängen von 40mm und 60mm auf, während das Sensorelement 10b Kantenlängen von 30mm und 60mm hat. Bei den Sensorelementen 10a und 10b sind die Elektrodenflächen 17a,17b, 18a, 18b, 19a, 19b sowie 20a, 20b jeweils rechteckförmig bzw. streifenförmig ausgebildet und abwechselnd beabstandet auf der Oberseite des jeweiligen Sensorelements 10a, 10b angeordnet. Das in der Fig. 5 dargestellte Sensorelement 10c weist demgegenüber in Draufsicht eine dreiecksförmige Form auf, wobei die Kantenlänge der beiden kurzen Schenkel beispielhaft jeweils 60mm beträgt. Während die einen Elektrodenflächen 17c und 19c jeweils streifenförmig ausgebildet sind, weisen die beiden anderen Elektrodenflächen 18c und 20c jeweils eine dreiecksförmige Form auf.

In der Fig. 8 ist ein Ausschnitt einer Sensorhaut 25 dargestellt, die aus einer Vielzahl von im Ausführungsbeispiel jeweils quadratisch ausgebildeten Sensorelementen 10 besteht. Die Sensorelemente 10 sind hierbei an ihren Seitenflächen sowohl mechanisch, z.B. in Form von Klettbändern, als auch elektrisch, beispielsweise in Form von nicht dargestellten Steckanschlüssen miteinander verbunden. Wesentlich hierbei ist, dass bei der elektrischen Verbindung der Sensorelemente 10 die jeweiligen ersten Messelemente 21 sowie die jeweiligen zweiten Messelemente 22 elektrisch miteinander verbunden sind. Es findet somit eine Verbindung in Form einer linearen Verkettung der Sensorelemente 10 statt.

Selbstverständlich ist es in Abänderung des in der Fig. 8 dargestellten Ausführungsbeispiels denkbar bzw. in der Praxis üblich, unterschiedlich geformte Sensorelemente 10, 10a, 10b, 10c miteinander mechanisch und elektrisch zu verbinden, um damit eine Sensorhaut 25 auszubilden, die der Form des zu überwachenden Maschinenteils, beispielsweise eines Arms eines Industrieroboters derart angepasst ist, dass die Sensorhaut 25 zum Beispiel um den Roboterarm herum gelegt werden kann. Hierzu ist es ebenfalls vorgesehen, dass das von der Sensorhaut 25 zu überwachende Maschinenteil und die Sensorhaut 25 miteinander verbunden sind, beispielsweise ebenfalls mit Klettelementen. Derartige Klettelemente ermöglichen ein schnelles Anlegen bzw. Abnehmen der Sensorhaut 25 von dem Maschinenbauteil. Zusätzlich kann die Sensorhaut 25 mit einer nichtleitenden, beispielsweise textilen Schutzschicht überzogen sein, die Feuchtigkeit, Schmutz und andere physikalische oder chemische Störeinflüsse von der Sensorhaut 25 fernhält. Die Feldlinien 1, 2 durchdringen dabei diese Schutzschicht, so dass die Sensorfunktion nicht beeinträchtigt wird.

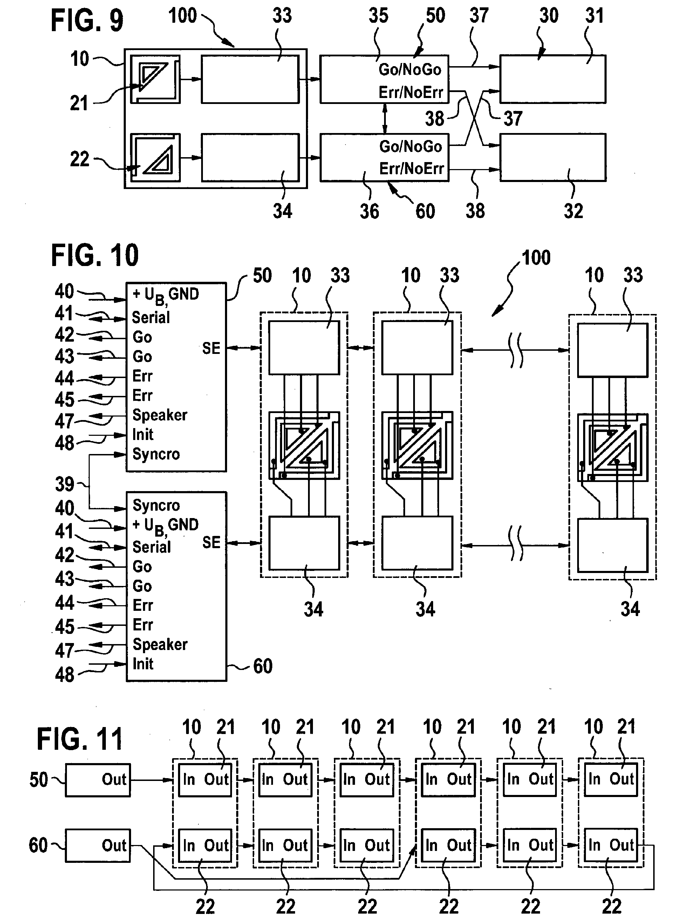

Das Sensorsystem 100 weist neben den bisher beschriebenen Sensorelementen 10, 10a, 10b und 10c zur Überwachung der beiden Messelemente 21, 22 der Sensorelemente 10, 10a, 10b, 10c zwei Zentraleinheiten 50, 60 auf, die nachfolgend noch näher beschrieben werden. Ferner umfasst das Sensorsystem 100 eine Computersoftware zur Applikation und Wartung des Sensorsystems 100 und Zubehörmaterial, beispielsweise Kabel, Klettband und Installationsmaterial, um das Sensorsystem 100 an dem zu überwachenden Bauteil zu befestigen. Das zu überwachende Bauteil, beispielsweise ein Teil eines Industrieroboters, weist eine in der Fig. 9 dargestellte Steuerung 30 auf, die zumindest, im Falle eines Industrieroboters, eine Robotersteuerung 31 und eine Sicherheitssteuerung 32 umfasst. Ferner erkennt man anhand der Fig. 9, dass das Sensorsystem 100 sowohl mit der Robotersteuerung 31, als auch mit der Sicherheitssteuerung 32, wirkverbunden ist. In der Fig. 9 ist das Sensorsystem 100 am Beispiel eines einzigen Sensorelements 10 mit seinen beiden Messelementen 21 und 22 dargestellt. Man erkennt, dass jedem der beiden Messelemente 21, 22 jeweils eine Eingangsstufe 33, 34 zugeordnet ist. Die Eingangsstufen 33, 34 sind hierbei insbesondere Bestandteil der in den Aussparungen 12, 13 angeordneten Elektronik des Sensorelements 10. Die beiden Eingangsstufen 33, 34 sind mit einer Auswertestufe 35, 36 wirkverbunden, die Bestandteil der Zentraleinheiten 50, 60 sind. Die beiden Auswertestufen 35, 36 weisen jeweils einen Go/No Go-Ausgang 37 auf, der mit der Robotersteuerung 31 verbunden ist, während ein Err/No Err-Ausgang 38 mit der Sicherheitssteuerung 32 wirkverbunden ist.

Wie bereits erläutert, werden die beiden Messelemente 21 und 22 jedes Sensorelements 10 zeitlich nacheinander angesteuert. Hierbei wird die Kapazität der Elektrodenflächen 17, 18 bzw. 19, 20 erfasst, und mit einem vorgegebenen Grenzwert bzw. vorgegebenen Grenzwerten verglichen. Bei einer bestimmten Änderungsgeschwindigkeit der Kapazität oder aber, wenn die Kapazität die zuvor angesprochenen Grenzwerte unter- bzw. überschreitet, wird daraus auf eine kollisionsgefährdende Annäherung zwischen dem Sensorelement 10 und einem Objekt, beispielsweise einem Menschen, geschlossen. In diesem Fall wird am jeweiligen Go/No Go-Ausgang 37 des jeweiligen Messelements 21, 22 ein No Go-Signal erzeugt, das der Robotersteuerung 31 als Eingangswert zugeführt wird. Daraufhin reagiert die Robotersteuerung 31 beispielsweise mit einer Verminderung der Bewegungsgeschwindigkeit oder einem Abstoppen des Handhabungsroboters. Hierzu genügt es, wenn an einem der beiden Messelemente 21, 22 eines Sensorelements 10 ein entsprechendes Signal erzeugt wird. Weiterhin werden die beiden Messelemente 21, 22, wie nachfolgend noch näher erläutert, einer sich zyklisch wiederholenden Eigendiagnose unterzogen, deren Ergebnis an dem Err/No Err-Ausgang 38 des jeweiligen Messelements 21, 22 ausgegeben wird. Falls innerhalb der Eigendiagnose beim ersten Messelement 21 oder beim zweiten Messelement 22 auf einen Fehler des Messelements 21, 22 geschlossen wird, wird ein entsprechendes Signal an dem Err/No Err-Ausgang 38 erzeugt und der Sicherheitsschaltung 32 als Eingangssignal zugeführt. Daraufhin spricht die Sicherheitssteuerung 32 an, indem beispielhaft ebenfalls der Betrieb des Industrieroboters gestoppt bzw. eingeschränkt wird. Es findet somit eine zweikanalige, voneinander unabhängige Überprüfung des Umfelds auf Annäherungen sowie eine entsprechende Eigendiagnose statt.

Die Auswertestufen 35, 36 sind, wie bereits erläutert, Bestandteil der jeweiligen Zentraleinheit 50 bzw. 60. In der Fig. 10 ist nunmehr der Fall dargestellt, bei dem eine beliebige Anzahl von Sensorelementen 10 elektrisch in Form einer Kette (sowie mechanisch) miteinander verbunden sind. Insbesondere erkennt man auch, dass die jeweiligen Eingangsstufen 33, 34 der jeweiligen Messelemente 21 bzw. 22 untereinander verbunden sind. Die beiden Zentraleinheiten 50, 60 fragen die jeweiligen Messelemente 21, 22 der Sensorelemente 10 nacheinander zyklisch an, wobei vorzugsweise vorgesehen ist, dass jedes der Sensorelemente 10 eine spezifische Adresse aufweist, anhand derer das jeweilige Sensorelement 10 hinsichtlich seiner Position in der Sensorhaut 25 identifiziert werden kann. Die beiden Zentraleinheiten 50, 60 sind über eine Verbindung 39 miteinander derart verbunden bzw. synchronisiert, dass die Abfrage bzw. Adressierung der einzelnen Sensorelemente 10 durch die Zentraleinheiten 50, 60 nacheinander erfolgt. Ferner erkennt man, dass die beiden Zentraleinheiten 50, 60 jeweils identisch ausgebildet sind und eine Spannungsversorgung 40, eine serielle Schnittstelle 41 zum optionalen Anschluss eines PCs, Ausgänge 42, 43 als Go- bzw. No Go-Signal für die Robotersteuerung 31, Ausgänge 44, 45 als Err bzw. No Err-Signal für die Sicherheitssteuerung 32, einen Anschluss 47 für einen Lautsprecher und einen Eingang 48 aufweisen, der mit der Robotersteuerung 31 verbunden ist.

In der Fig. 11 ist der zeitliche Ablauf einer möglichen Ansteuerung der Sensorelemente 10 durch die Zentraleinheiten 50, 60 dargestellt: Man erkennt insbesondere, dass bei beispielhaft sechs Sensorelementen 10 die eine Zentraleinheit 50 die jeweiligen ersten Messelemente 21 nacheinander, beginnend mit dem ersten Sensorelement 10, ansteuert. Demgegenüber steuert die zweite Zentraleinheit 60 in einem Zeitpunkt, bei dem die erste Zentraleinheit 50 das erste Messelement 21 des ersten Messelements 10 ansteuert, das vierte Sensorelement 10 an seinem zweiten Messelement 22 an. Darauffolgend wird das fünfte und das sechste Sensorelement 10, und nachfolgend die ersten drei Sensorelemente 10 angesteuert. Mit anderen Worten gesagt bedeutet dies, dass in ein und demselben Zeitpunkt zwar beide Zentraleinheiten 50, 60 jeweils ein Sensorelement 10 an seinem jeweiligen Messelement 21 bzw. 22 ansteuern, dass jedoch niemals gleichzeitig beide Messelemente 21, 22 an ein und demselben Sensorelement 10 von den Zentraleinheiten angesteuert werden.

Die Adressierung der jeweiligen Sensorelemente 10 durch die Zentraleinheiten 50, 60 erfolgt elektronisch durch ein Schieberegister. Nach jedem Zyklus einer Hauptprogrammschleife wird jedes Sensorelement 10 einmal ausgelesen und im RAM-Bereich des Mikrokontrollers abgespeichert.

Alle Sensorelemente 10, Verbindungskabel und der Mikrokontroller werden einer zyklischen Eigendiagnose unterzogen, um bei Fehlfunktion beispielsweise den Industrieroboter sicher abzuschalten. Während die Zentraleinheiten 50, 60 und deren Anschlusskabel üblicherweise fest in einem Schaltschrank montiert sind, sind die Sensorelemente 10 und deren Verbindungskabel der Bewegung beispielsweise des Roboterarms und möglichen Kollisionen ausgesetzt. Jedes Sensorelement 10 wird mehrmals pro Sekunde vollständig von der Eigendiagnose überprüft. Unterbrechungen, Schlüsse gegen Masse, Schlüsse gegen Betriebsspannungen, ein Ausfall elektronischer Bauelemente sowie weitere Fehler werden erkannt. Hierbei werden die Fehler beispielhaft anhand von sechs Diagnosekriterien diagnostiziert. Diese Diagnosekriterien können beispielsweise nach der Beaufschlagung der Sensorelemente 10 mit Prüfspannungen oder charakteristischen Signalmustern erzeugt werden, wobei es genügt, dass eines der sechs Diagnosekriterien anspricht, um bei der Eigendiagnose ein entsprechendes Fehlersignal zu erzeugen.

Das soweit beschriebene Sensorsystem 100 bzw. die Sensorelemente 10, 10a, 10b, 10c sowie der Anschluss an eine Steuerung können in vielfältiger Art und Weise abgewandelt bzw. modifiziert werden ohne vom Erfindungsgedanken abzuweichen. So ist es insbesondere denkbar, dass die Sensorelemente 10, 10a, 10b, 10c andere Maße oder andere Formen aufweisen. Ebenso sind anders ausgebildete Elektrodenflächenanordnungen denkbar. Weiterhin ist es denkbar, dass anstelle von analogen Messwerten bzw. Signalübertragungen digitale Signalübertragungen vom Sensorelement 10, 10a, 10b, 10c an die jeweilige Zentraleinheit 50, 60 stattfinden.

Anstelle eines modularen Aufbaus der Sensorhaut 25 aus Basiselementen bzw. einzelnen Sensorelementen 10, 10a, 10b, 10c, die miteinander verbunden sind, kann ein monolithisches Herstellungsverfahren eingesetzt werden, mit dem eine komplette Sensorhaut 25 aus einem Stück gefertigt wird (z.B. durch Umspritzen, Fertigung als Strangware). Weiterhin kann zur Steigerung der Sicherheit beim Betrieb des Sensorsystems 100 jedes der Sensorelemente 10, 10a, 10b, 10c anstelle zweier, voneinander unabhängig arbeitender Messelemente 21, 22 eine größere Anzahl von Messelementen, beispielsweise drei oder vier Messelemente, aufweisen.

Das System kann in unterschiedlichen Anwendungsbereichen eingesetzt werden, beispielsweise an Industrierobotern oder Servicerobotern, mobilen Plattformen, Fahrzeugen (insbesondere unbemannten), in der Medizintechnik oder in der Unterhaltungsindustrie.

Neben der Sicherheitsfunktion kann das Sensorsystem 10 andere oder zusätzliche Umfeld-Überwachungsfunktionen übernehmen. Beispielsweise kann die Interaktion eines Roboters mit seinem Umfeld oder eine Gestenerkennung erfolgen, indem eine Steuerung die Sensordaten mit der Information über die räumliche Anordnung der Sensorelemente 10, 10a, 10b, 10c verknüpft und interpretiert. Auch die zeitliche Entwicklung der Sensordaten kann hierzu nützliche Informationen liefern.

In einer Abwandlung kann eine Kapazitätsmessung durchgeführt werden, indem der Sende- und Empfangsbetrieb auf zwei oder mehr Sensorelemente 10, 10a, 10b, 10c verteilt ist. Die Feldlinien 1, 2 des Messfeldes erstrecken sich dann über einen größeren Basisabstand, dadurch wird die Reichweite vergrößert und mögliche Lücken zwischen den Sensorelementen 10, 10a, 10b, 10c werden geschlossen.

## Patentansprüche

1. Sensorsystem (100) zur Umfeldüberwachung an einem mechanischen Bauteil, mit mindestens einem kapazitiven Sensorelement (10; 10a; 10b; 10c), das an der Oberfläche von Maschinen oder Maschinenteilen anbringbar ist, wobei das mindestens eine Sensorelement (10; 10a; 10b; 10c) aus einem Schichtaufbau von flexiblen, elektrisch leitfähigen und elektrisch isolierenden Lagen (14, 15, 16, 17; 17a bis 17c, 18; 18a bis 18c, 19; 19a bis 19c, 20; 20a bis 20c) aufgebaut ist, wobei elektrisch leitfähige Potentialflächen einer Lage (17; 17a bis 17c, 18; 18a bis 18c, 19; 19a bis 19c) seitlich derart beabstandet über dazwischen liegende isolierende Lagen (14, 15, 16) angeordnet sind, dass sich elektrische Feldlinien (1, 2) zwischen den leitenden Potentialflächen (17; 17a bis 17c, 18; 18a bis 18c, 19; 19a bis 19c, 20; 20a bis 20c) herausbilden, die sich bei Annäherung eines Körpers oder eines Objekts messbar verändern, wobei der Schichtaufbau eines Sensorelements (10; 10a; 10b; 10c) wenigstens zwei voneinander getrennt arbeitende Messelemente (21, 22) aufweist, wobei das Sensorelement (10; 10a; 10b; 10c) Mittel (50, 60) zum separaten Ansteuern und Auswerten der wenigstens zwei Messelemente (21, 22) umfasst, und wobei die elektrisch leitfähigen Potenzialflächen (17; 17a bis 17c, 18; 18a bis 18c, 19; 19a bis 19c, 20; 20a bis 20c) als Sende- oder Empfangselektroden wirken,
**dadurch gekennzeichnet,**
**dass** die Mittel (50, 60) für jedes der Messelemente (21, 22) eines Sensorelements (10; 10a; 10b; 10c) jeweils eine separate Eingangsstufe (33, 34) aufweist.

2. Sensorsystem nach Anspruch 1,
**dadurch gekennzeichnet,**
**dass** die Mittel (50, 60) die wenigstens zwei Messelemente (21, 22) zeitlich aufeinanderfolgend ansteuern.

3. Sensorsystem nach Anspruch 1 bis 2,
**dadurch gekennzeichnet,**
**dass** Auswertemittel (35, 36) zum Auswerten der Messsignale der wenigstens zwei Messelemente (21, 22) vorgesehen sind, und dass die Auswertemittel (35, 36) mit den Maschinen oder Maschinenteilen zumindest mittelbar wirkverbunden sind und diese derart ansteuern, dass ein Betrieb der Maschinen oder Maschinenteile nur erfolgt, wenn die Signale der wenigstens zwei Messelemente (21, 22) innerhalb vorgegebener Grenzwerte liegen.

4. Sensorsystem nach einem der Ansprüche 1 bis 3,
**dadurch gekennzeichnet,**
**dass** das mindestens eine Sensorelement (10; 10a; 10b; 10c) eine Grundfläche mit der Form eines Drei- oder Vierecks aufweist, und dass beim Vorhandensein mehrerer Sensorelemente (10; 10a; 10b; 10c) diese miteinander elektrisch und mechanisch kontaktierbar sind und vorzugsweise eine Sensorhaut (25) ausbilden.

5. Sensorsystem nach einem der Ansprüche 1 bis 4,
**dadurch gekennzeichnet,**
**dass** die wenigstens zwei Messelemente (21, 22) elektrisch voneinander getrennt ausgebildet sind.

6. Sensorsystem nach einem der Ansprüche 1 bis 5,
**dadurch gekennzeichnet,**
**dass** die Messelemente (21, 22) auf wenigstens einer Schicht gemeinsam angeordnet und räumlich voneinander getrennt sind.

7. Sensorsystem nach einem der Ansprüche 1 bis 6,
**dadurch gekennzeichnet,**
**dass** die isolierenden Lagen (14, 15, 16) als zwei Masseelektroden und eine zwischen den Masseelektroden und den leitenden Potentialflächen (17; 17a bis 17c, 18; 18a bis 18c, 19; 19a bis 19c, 20; 20a bis 20c) angeordnete Isolierschicht ausgebildet sind.

8. Verfahren zur Ansteuerung und Auswertung eines Sensorsystems, das nach einem der Ansprüche 1 bis 7 ausgebildet ist,
**dadurch gekennzeichnet,**
**dass** beim Vorhandensein mehrerer Sensorelemente (10; 10a; 10b; 10c) wenigstens eine elektronische Auswerteeinrichtung mit Mitteln (50, 60) vorgesehen ist, die zyklisch die Sensorelemente (10; 10a; 10b; 10c) adressiert und prüft, ob bei mindestens einem Sensorelement (10; 10a; 10b; 10c) eine signifikante Veränderung der Kapazität gegenüber einem Referenzwert stattgefunden hat, und dass die Mittel (50, 60) die wenigstens zwei Messelemente (21, 22) eines Sensorelements (10; 10a; 10b; 10c) zeitlich nacheinander adressieren.

9. Verfahren nach Anspruch 8,
**dadurch gekennzeichnet,**
**dass** zum gleichen Zeitpunkt ein Messelement (21, 22) eines ersten Sensorelements (10; 10a; 10b; 10c) und ein anderes Messelement (22, 21) eines anderen Sensorelements (10; 10a; 10b; 10c) von den Mitteln (50, 60) adressiert werden.

10. Verfahren nach einem der Ansprüche 8 oder 9,
**dadurch gekennzeichnet,**
**dass** zur Adressierung linear verketteter Sensorelemente (10; 10a; 10b; 10c) die Reihenfolge der Sensorelemente (10; 10a; 10b; 10c) genutzt wird, indem die Information zur Aktiveirung eines Sensorelements (10; 10a; 10b; 10c) entlang der Kette über mehrere Sensorelementen (10; 10a; 10b; 10c) weitergeleitet werden.

11. Verfahren nach Anspruch 10,
**dadurch gekennzeichnet,**
**dass** in einem weiteren Zyklus jedes Sensorelement (10; 10a; 10b; 10c) einer Eigendiagnose unterzogen wird, wobei die Sensorelemente (10; 10a; 10b; 10c) mit Prüfspannungen oder einem charakteristischen Signalmuster beaufschlagt werden.

## Claims

1. Sensor system (100) for monitoring the surroundings on a mechanical component, having at least one capacitive sensor element (10; 10a; 10b; 10c) which can be fitted to the surface of machines or machine parts, the at least one sensor element (10; 10a; 10b; 10c) being constructed from a layer structure of flexible, electrically conductive and electrically insulating layers (14, 15, 16, 17; 17a to 17c, 18; 18a to 18c, 19; 19a to 19c, 20; 20a to 20c), electrically conductive potential areas of a layer (17; 17a to 17c, 18; 18a to 18c, 19; 19a to 19c) being arranged at a lateral distance via insulating layers (14, 15, 16) in between in such a manner that electrical field lines (1, 2) are formed between the conductive potential areas (17; 17a to 17c, 18; 18a to 18c, 19; 19a to 19c, 20; 20a to 20c) and change in a measurable manner when a body or an object approaches, the layer structure of a sensor element (10; 10a; 10b; 10c) having at least two measuring elements (21, 22) which operate separately from one another, the sensor element (10; 10a; 10b; 10c) comprising means (50, 60) for separately controlling and evaluating the at least two measuring elements (21, 22), and the electrically conductive potential areas (17; 17a to 17c, 18; 18a to 18c, 19; 19a to 19c, 20; 20a to 20c) acting as transmitting or receiving electrodes,
**characterized in that**
the means (50, 60) for each of the measuring elements (21, 22) of a sensor element (10; 10a; 10b; 10c) each have a separate input stage (33, 34).

2. Sensor system according to Claim 1,
**characterized in that**
the means (50, 60) control the at least two measuring elements (21, 22) in temporal succession.

3. Sensor system according to Claims 1 and 2,
**characterized in that**
evaluation means (35, 36) for evaluating the measurement signals from the at least two measuring elements (21, 22) are provided, and **in that** the evaluation means (35, 36) are at least indirectly operatively connected to the machines or machine parts and control the latter in such a manner that the machines or machine parts are operated only when the signals from the at least two measuring elements (21, 22) are within predefined limit values.

4. Sensor system according to one of Claims 1 to 3,
**characterized in that**
the at least one sensor element (10; 10a; 10b; 10c) has a base area with the shape of a triangle or square, and **in that**, when there are a plurality of sensor elements (10; 10a; 10b; 10c), the latter can be electrically and mechanically connected to one another and preferably form a sensor skin (25).

5. Sensor system according to one of Claims 1 to 4,
**characterized in that**
the at least two measuring elements (21, 22) are electrically separate from one another.

6. Sensor system according to one of Claims 1 to 5,
**characterized in that**
the measuring elements (21, 22) are arranged together on at least one layer and are spatially separate from one another.

7. Sensor system according to one of Claims 1 to 6,
**characterized in that**
the insulating layers (14, 15, 16) are in the form of two earth electrodes and an insulating layer which is arranged between the earth electrodes and the conductive potential areas (17; 17a to 17c, 18; 18a to 18c, 19; 19a to 19c, 20; 20a to 20c).

8. Method for controlling and evaluating a sensor system designed according to one of Claims 1 to 7,
**characterized in that**
when there are a plurality of sensor elements (10; 10a; 10b; 10c), at least one electronic evaluation device having means (50, 60) is provided, which evaluation device cyclically addresses the sensor elements (10; 10a; 10b; 10c) and checks whether a significant change in the capacitance with respect to a reference value has taken place in at least one sensor element (10; 10a; 10b; 10c), and **in that** the means (50, 60) address the at least two measuring elements (21, 22) of a sensor element (10; 10a; 10b; 10c) in temporal succession.

9. Method according to Claim 8,
**characterized in that**
a measuring element (21, 22) of a first sensor element (10; 10a; 10b; 10c) and another measuring element (22, 21) of another sensor element (10;
10a; 10b; 10c) are addressed by the means (50, 60) at the same time.

10. Method according to either of Claims 8 and 9,
**characterized in that**
the sequence of the sensor elements (10; 10a; 10b; 10c) is used to address linearly concatenated sensor elements (10; 10a; 10b; 10c) by virtue of the information for activating a sensor element (10; 10a; 10b; 10c) being forwarded via a plurality of sensor elements (10; 10a; 10b; 10c) along the chain.

11. Method according to Claim 10,
**characterized in that**
each sensor element (10; 10a; 10b; 10c) is subjected to a self-diagnosis in a further cycle, test voltages or a characteristic signal pattern being applied to the sensor elements (10; 10a; 10b; 10c).

## Revendications

1. Système de détection (100) destiné à la surveillance de l'environnement sur un composant mécanique, comprenant au moins un élément de détection capacitif (10 ; 10a ; 10b ; 10c) qui peut être monté sur la surface de machines ou de pièces de machine, ledit un élément de détection (10 ; 10a ; 10b ; 10c) étant constitué d'une structure stratifiée de couches flexibles, électriquement conductrices et électriquement isolantes (14, 15, 16, 17 ; 17a à 17c, 18 ; 18a à 18c, 19 ; 19a à 19c, 20 ; 20a à 20c), les surfaces à potentiel électriquement conductrices d'une couche (17 ; 17a à 17c, 18 ; 18a à 18c, 19 ; 19a à 19c) étant disposées espacées latéralement par des couches isolantes (14, 15, 16) se trouvant entre elles de telle sorte qu'il se forme des lignes de champ électriques (1, 2) entre les surfaces à potentiel conductrices (17 ; 17a à 17c, 18 ; 18a à 18c, 19 ; 19a à 19c, 20 ; 20a à 20c), lesquelles varient de manière mesurable lors de l'approche d'un corps ou d'un objet, la structure stratifiée d'un élément de détection (10 ; 10a ; 10b ; 10c) possédant au moins deux éléments de mesure (21, 22) fonctionnant indépendamment l'un de l'autre, l'élément de détection (10 ; 10a ; 10b ; 10c) comprenant des moyens (50, 60) destinés à commander et à interpréter séparément lesdits deux éléments de mesure (21, 22) et les surfaces à potentiel électriquement conductrices (17 ; 17a à 17c, 18 ; 18a à 18c, 19 ; 19a à 19c, 20 ; 20a à 20c) faisant office d'électrodes d'émission ou de réception,
**caractérisé en ce**
**que** les moyens (50, 60) possèdent respectivement un étage d'entrée (33, 34) distinct pour chacun des éléments de mesure (21, 22) d'un élément de détection (10 ; 10a ; 10b ; 10c).

2. Système de détection selon la revendication 1, **caractérisé en ce que** les moyens (50, 60) commandent lesdits deux éléments de mesure (21, 22) successivement dans le temps.

3. Système de détection selon les revendications 1 à 2, **caractérisé en ce qu'**il existe des moyens d'interprétation (35, 36) destinés à interpréter les signaux de mesure desdits deux éléments de mesure (21, 22), et **en ce que** les moyens d'interprétation (35, 36) sont en liaison active au moins indirectement avec les machines ou les pièces de machine et commandent celles-ci de telle sorte qu'un fonctionnement des machines ou des pièces de machine n'a lieu que si les signaux desdits deux éléments de mesure (21, 22) se trouvent à l'intérieur de valeurs limites prédéfinies.

4. Système de détection selon l'une des revendications 1 à 3, **caractérisé en ce que** l'au moins un élément de détection (10 ; 10a ; 10b ; 10c) possède une surface de base sous la forme d'un triangle ou d'un quadrilatère, et **en ce qu'**en présence de plusieurs éléments de détection (10 ; 10a ; 10b ; 10c), ceux-ci peuvent être mis en contact électrique et mécanique et forment de préférence une membrane de détection (25).

5. Système de détection selon l'une des revendications 1 à 4, **caractérisé en ce que** lesdits deux éléments de mesure (21, 22) sont configurés isolés électriquement l'un de l'autre.

6. Système de détection selon l'une des revendications 1 à 5, **caractérisé en ce que** les éléments de mesure (21, 22) sont disposés en commun sur au moins une couche et sont séparés dans l'espace l'un de l'autre.

7. Système de détection selon l'une des revendications 1 à 6, **caractérisé en ce que** les couches isolantes (14, 15, 16) sont réalisées sous la forme de deux électrodes de masse et d'une couche isolante disposée entre les électrodes de masse et les surfaces à potentiel conductrices (17 ; 17a à 17c, 18 ; 18a à 18c, 19 ; 19a à 19c, 20 ; 20a à 20c).

8. Procédé de commande et d'interprétation d'un système de détection qui est configuré selon l'une des revendications 1 à 7, **caractérisé en ce qu'**en présence de plusieurs éléments de détection (10 ; 10a ; 10b ; 10c), il existe au moins un dispositif d'interprétation électronique comprenant des moyens (50, 60) qui s'adressent de manière cyclique aux éléments de détection (10 ; 10a ; 10b ; 10c) et vérifient si une modification importante de la capacité par rapport à une valeur de référence s'est produite au niveau d'au moins un élément de détection (10 ; 10a ; 10b ; 10c), et **en ce que** les moyens (50, 60) s'adressent successivement dans le temps auxdits deux éléments de mesure (21, 22) d'un élément de détection (10 ; 10a ; 10b ; 10c).

9. Procédé selon la revendication 8, **caractérisé en ce qu'**un élément de mesure (21, 22) d'un premier élément de détection (10 ; 10a ; 10b ; 10c) et un autre élément de mesure (22, 21) d'un autre élément de détention (10 ; 10a ; 10b ; 10c) sont adressés par les moyens (50, 60) au même instant.

10. Procédé selon l'une des revendications 8 ou 9, **caractérisé en ce que** l'ordre des éléments de détection (10 ; 10a ; 10b ; 10c) est utilisé pour l'adressage des éléments de détection (10 ; 10a ; 10b ; 10c) chaînés linéairement **en ce que** l'information servant à l'activation d'un élément de détection (10 ; 10a ; 10b ; 10c) est transmise le long de la chaîne sur plusieurs éléments de détection (10 ; 10a ; 10b ; 10c).

11. Procédé selon la revendication 10, **caractérisé en ce que** chaque élément de détection (10 ; 10a ; 10b ; 10c) est soumis à un autodiagnostic au cours d'un cycle supplémentaire, les éléments de détection (10 ; 10a ; 10b ; 10c) étant alimentés avec des tensions d'essai ou un modèle de signal caractéristique.
